# EUROPÄISCHE PATENTSCHRIFT

(11) **EP 2 782 248 B1**
(45) Veröffentlichungstag und Bekanntmachung des Hinweises auf die Patenterteilung: **23.09.2015**
(21) Anmeldenummer: 14000776.6
(22) Anmeldetag: 04.03.2014
(51) Int. Cl.: H03F 1/52, H03F 3/54, H03F 3/60, H04B 7/185, H04B 17/00, H03F 3/189, H03F 3/58, H04B 17/17

(54) **Verfahren zum Betreiben eines Verstärkermoduls eines Satelliten**
Method for operating an amplifier module of a satellite
Procédé de fonctionnement d'un module d'amplification d'un satellite

(30) Priorität: 19.03.2013 DE 102013004673
(43) Veröffentlichungstag der Anmeldung: 24.09.2014
(73) Patentinhaber: Tesat-Spacecom GmbH & Co. KG, 71522 Backnang (DE)
(72) Erfinder: Reinwald, Gerhard, 71546 Aspach (DE); Katz, Hanspeter, 70374 Stuttgart (DE)
(74) Vertreter: Avenhaus, Beate

(56) Entgegenhaltungen:
- EP-A2- 0 623 994
- EP-A2- 1 478 088
- WO-A1-84/04215
- DE-A1-102004 018 137
- US-A1- 2002 177 404
- US-A1- 2003 231 057
- US-A1- 2006 103 460
- US-A1- 2010 291 866

## Beschreibung

### GEBIET DER ERFINDUNG

Die Erfindung betrifft ein Verfahren zum Betreiben eines Verstärkermoduls eines Kommunikationssatelliten sowie ein Verstärkermodul.

### HINTERGRUND DER ERFINDUNG

Als Leistungsverstärker werden in Satelliten vornehmlich Wanderfeldröhrenverstärker (TWTA, Travelling Wave Tube Amplifier) eingesetzt, die in der Regel als Wanderfeldröhrenmodule ausgeführt sind. Diese umfassen eine Wanderfeldröhre, die vornehmlich die Hochfrequenz-Eigenschaften bestimmt, und eine Stromversorgung, die die Versorgungsspannungen für die Wanderfeldröhre erzeugt, eine Telemetrie- und/oder Telekommando-Schnittstelle zum Satelliten, sowie eine Steuerung. Ergänzt werden kann das Wanderfeldröhrenmodul durch einen Vorverstärker (auch Kanalverstärker genannt), der auch einen Linearisierer beinhalten kann. Der Vorverstärker kann mit den anderen Komponenten in einem Gehäuse integriert sein. In dieser Kombination spricht man dann von einem Hochfrequenz-Leistungsmodul.

Wanderfeldröhrenmodule und im Allgemeinen Verstärkermodule können auch einen Schutzfunktionsbaustein umfassen, in dem eine oder mehrere Schutzfunktionen ausgeführt werden, um den Verstärker vor Beschädigung zu schützen, beispielsweise gegen eine zu niedrige Versorgungsspannung, eine Überlast an den Ausgängen der Stromversorgung, einem zu hohen Strom auf der Verzögerungsstruktur usw. Wird eine dieser Schutzfunktionen aktiviert, schaltet sich das Verstärkermodul automatisch ab.

In der Regel wird eine Bodenstation über Telemetriedaten, die vom Satelliten an die Bodenstation gesendet werden, über das Abschalten bzw. auch über ein erfolgreiches Wiedereinschalten des Verstärkermoduls informiert. Aus den Telemetriedaten kann allerdings nicht erkannt werden, warum das Gerät die Fehlfunktion gezeigt hat bzw. welche Schutzfunktion aktiv war.

Im Allgemeinen werden Telemetriedaten entweder als analoger Wert bei analogen Daten bzw. digitale Information bei Statusdaten oder bereits digitalisiert als digitales Wort vom Verstärkermodul dem Satelliten zur Verfügung gestellt. Ein System des Satelliten liest die Daten in regelmäßigen Intervallen aus, wobei die Zeit zwischen zwei Lesevorgängen in der Regel mehrere Sekunden (z.B. 60 s) beträgt. War eine automatische Wiedereinschaltung des Verstärkermoduls erfolgreich, so wird dies durch eine entsprechende Statustelemetrie angezeigt. Aus diesen Daten kann in der Regel aber nicht festgestellt werden, welcher Parameter die Schutzfunktion ausgelöst hat. Auch sind die Telemetriedaten aufgrund der langen Leseintervalle nicht zeitnah vorhanden.

Für Deep-Space-Missionen wurden Geräte entwickelt, die im Falle einer Fehlfunktion zusätzlich anzeigen, welcher Parameter die Schutzfunktion ausgelöst hat. Wird das Gerät allerdings durch die Schutzfunktion komplett abgeschaltet, geht diese Information verloren. Des Weiteren werden keine zeitnahen Daten der Telemetrien bereitgestellt.

### ZUSAMMENFASSUNG DER ERFINDUNG

Es ist Aufgabe der Erfindung, ein leicht zu wartendes Verstärkermodul für einen Satelliten bereitzustellen.

Diese Aufgabe wird durch den Gegenstand der unabhängigen Ansprüche gelöst. Weitere Ausführungsformen der Erfindung ergeben sich aus den abhängigen Ansprüchen und aus der folgenden Beschreibung.

Ein Aspekt der Erfindung betrifft ein Verfahren zum Betreiben eines Verstärkermoduls eines Kommunikationssatelliten.

Das Verstärkermodul kann eine Verstärkereinheit und eine Steuerung zum Ansteuern der Verstärkereinheit umfassen. Es ist zu verstehen, dass der Kommunikationssatellit eine Mehrzahl von Verstärkermodulen aufweisen kann, die jeweils einem Kanal des Satelliten zugeordnet sein können.

Das Verstärkermodul kann ein Wanderfeldröhrenmodul sein, bei dem die Verstärkung durch eine Wanderfeldröhre stattfindet. Es ist aber auch möglich, dass das Verstärkermodul ein Halbleiterverstärkermodul mit einem Halbleiterverstärker ist.

Gemäß einer Ausführungsform der Erfindung umfasst das Verfahren die Schritte von: Feststellen eines ungewünschten Zustandes des Verstärkermoduls; Abspeichern von Zustandsdaten, die auf den ungewünschten Zustand hinweisen, in einem nicht-flüchtigen Speicher des Verstärkermoduls, nachdem der ungewünschte Zustand festgestellt wurde; und Deaktivieren des Verstärkermoduls nach dem Abspeichern der Zustandsdaten.

Es kann als Kern der Erfindung aufgefasst werden, dass (kurz) vor dem Deaktivieren des Verstärkermoduls aufgrund einer Fehlfunktion, d.h. eines ungewünschten Zustands, Information über die Fehlfunktion, d.h. zeitnahe Zustandsdaten, in einem nicht-flüchtigen Speicher abgespeichert werden, so dass diese auch dann noch zur Verfügung stehen, wenn das Verstärkermodul aufgrund der Deaktivierung eine Zeit von der Stromversorgung des Satelliten getrennt war.

Beim Auftreten von Fehlfunktionen kann der Betreiber des Satelliten auf diese Weise erfahren, welcher Fehler vorlag, insbesondere wenn der Betrieb des Verstärkermoduls auf Dauer beeinträchtigt ist. Außerdem liegen auch Informationen für schnell ablaufende Vorgänge (wie etwa das Erkennen einer Fehlfunktion, eines ungewünschten Zustands) im Verstärkermodul vor, die von einer langsamen, regelmäßigen Datenabfrage (die etwa alle 60 s stattfinden kann) nicht erfasst werden.

Ein ungewünschter Zustand kann beispielsweise ein bestehender Fehler, eine Fehlfunktion oder ein in Kürze eintretender Fehler sein. Ein ungewünschter Zustand kann sein, dass ein bestimmter Betriebsparameter bzw. Messwert einen vorgegebenen Schwellwert über- oder unterschreitet.

Der nicht-flüchtige Speicher ist in der Regel dazu ausgeführt, den Umweltbedingungen im Weltraum standzuhalten, d.h., der nicht-flüchtige Speicher kann resistent gegenüber Temperaturschwankungen in einem großen Bereich und/oder resistent gegenüber Strahlung sein. Die Umweltbedingungen, denen ein Satellit im Betrieb ausgesetzt ist, halten den Fachmann normalerweise davon ab, eine Vielzahl von elektronischen Komponenten zu verbauen, die nicht oder nur schwer auszutauschen sind, wenn sich der Satellit im Orbit befindet.

Unter dem Deaktivieren des Verstärkermoduls kann dabei ein Ausschalten des Verstärkermoduls verstanden werden, bei dem das Verstärkermodul beispielsweise von einer Stromversorgung des Satelliten getrennt wird. Analog kann unter dem Aktivieren des Verstärkermoduls ein Einschalten bzw. Verbinden des Verstärkermoduls mit der Stromversorgung des Satelliten verstanden werden. Gemäß einer Ausführungsform der Erfindung wird der ungewünschte Zustand durch Ausführen einer Schutzfunktion festgestellt, die auf erfasste Parameter des Verstärkermoduls angewendet wird, und die aus den erfassten Parametern den ungewünschten Zustand ermittelt. Die erfassten Parameter können beispielsweise Messwerte und/oder Betriebsparameter umfassen, wie etwa einen Eingangsstrom oder eine Eingangsleistung des Verstärkermoduls bzw. eine Reglerspannung, eine Versorgungsspannung bzw. ein Strom einer Wanderfeldröhre. Die erfassten Parameter können aber auch einstellbare Parameter wie etwa Konfigurationsparameter sein.

Die Schutzfunktion kann beispielsweise vergleichen, ob sich der Parameter oberhalb oder unterhalb eines Schwellwerts befindet oder sich innerhalb oder außerhalb eines vordefinierten Intervalls befindet. Beispielsweise kann die Schutzfunktion feststellen, dass die Eingangsleistung des Verstärkermoduls unterhalb eines bestimmten Werts gesunken ist, was dann als ungewünschter Zustand erkannt wird.

Gemäß einer Ausführungsform der Erfindung umfassen die abgespeicherten Zustandsdaten die Art der Schutzfunktion. Beispielsweise kann in einem digitalen Wort kodiert abgespeichert werden, welche Schutzfunktion angesprochen hat.

Gemäß einer Ausführungsform der Erfindung umfassen die abgespeicherten Zustandsdaten Werte von Parametern, die durch die Schutzfunktion verarbeitet wurden. Diese Werte können beispielsweise ein Betriebsparameter (wie etwa die Eingangsleistung) und optional der zugehörige Schwellwert sein.

Gemäß einer Ausführungsform der Erfindung umfassen die abgespeicherten Zustandsdaten Werte von Parametern des Verstärkermoduls, die (kurz) vor dem Feststellen des ungewünschten Zustands erfasst (beispielsweise gemessen und/oder aus Messwerten berechnet) wurden und/oder die (kurz) vor dem Deaktivieren des Verstärkermoduls erfasst wurden. Beispielsweise kann ein vordefinierter Satz von Betriebsparametern und/oder einstellbaren Parametern als Zustandsdaten gespeichert werden. In diesem Zusammenhang kann "kurz" beispielsweise weniger als 10 ms oder weniger als 1 ms bedeuten.

Gemäß einer Ausführungsform der Erfindung umfasst das Verfahren weiter die Schritte von: Feststellen eines weiteren ungewünschten Zustandes und Abspeichern von weiteren Zustandsdaten, die den weiteren ungewünschten Zustand betreffen, so dass die Zustandsdaten und die weiteren Zustandsdaten zusammen in dem nicht-flüchtigen Speicher gespeichert sind. Es ist nicht nur möglich, dass die Zustandsdaten zu lediglich einem (d.h. dem jüngsten) ungewünschten Zustand in dem nicht-flüchtigen Speicher gespeichert werden, sondern zu einer Mehrzahl von ungewünschten Zuständen, beispielsweise einer festen Anzahl von zuvor aufgetretenen ungewünschten Zuständen.

Wenn beispielsweise aus betriebstechnischen Gründen die Daten zu einem ungewünschten Zustand von der Bodenstation nicht ausgelesen werden konnten, steht die Information noch zur Verfügung, auch wenn zwischenzeitlich weitere ungewünschte Zustände aufgetreten sind.

Es ist auch möglich, dass die abgespeicherten Zustandsdaten einen Zeitwert umfassen, der auf einen Zeitpunkt hinweist, zu dem der ungewünschte Zustand festgestellt wurde. Werden mehrere Sätze Zustandsdaten gespeichert, kann auch die Zeit zwischen zwei ungewünschten Zuständen ebenfalls abgespeichert werden, um diese zeitlich zuordnen zu können.

Um die Unterbrechung der Verstärkerfunktion des Verstärkermoduls möglichst kurz zu halten, weisen manche Verstärkermodule einen Automatismus auf, der versucht, das Verstärkermodul nach einer kurzen Wartezeit (beispielsweise einige Millisekunden) wieder einzuschalten. Ist danach die Fehlfunktion behoben, bleibt das Verstärkermodul eingeschaltet, ist die Fehlfunktion nach wie vor vorhanden, schaltet das Verstärkermodul endgültig ab. Das Gleiche kann auch gelten, wenn innerhalb kurzer Zeit wieder eine Fehlfunktion eintritt. Auch in diesen Fällen können mehrere Sätze von Zustandsdaten in dem nicht-flüchtigen Speicher gespeichert werden.

Gemäß einer Ausführungsform der Erfindung umfasst das Verfahren weiter den Schritt von: Senden der abgespeicherten Zustandsdaten an eine Bodenstation. Beispielsweise, nachdem das Verstärkermodul wieder aktiviert bzw. eingeschaltet wurde, kann die Information über den ungewünschten Zustand über einen Telemetriekanal ausgelesen werden. Wurde das Verstärkermodul automatisch wieder aktiviert, kann die Information ebenfalls zum Auslesen bereitstehen.

Zusätzlich ist möglich, dass die Betriebsparameter und/oder im Moment eingestellte Parameter des Verstärkermoduls in Intervallen von mehreren Sekunden (beispielsweise alle 30 s oder alle 60 s) ausgelesen und an die Bodenstation gesendet werden, auch wenn kein ungewünschter Zustand bzw. keine Fehlfunktion eingetreten ist.

Gemäß einer Ausführungsform der Erfindung werden die abgespeicherten Zustandsdaten versendet, wenn das Verstärkermodul ein entsprechendes Telekommando von der Bodenstation erhält. Beispielsweise kann die Bodenstation eine entsprechende Anfrage (Telekommando) an das Verstärkermodul schicken und dieses stellt dann die entsprechenden Zustandsdaten zum Auslesen bereit bzw. sendet sie über einen oder mehrere Telemetriekanäle zur Bodenstation.

Gemäß einer Ausführungsform der Erfindung werden die abgespeicherten Zustandsdaten automatisch versendet, nachdem das Verstärkermodul reaktiviert wurde. Beispielsweise, nachdem das Verstärkermodul über ein Telekommando oder automatisch wieder eingeschaltet wurde, können die Zustandsdaten in Reaktion auf die Reaktivierung automatisch an die Bodenstation versendet werden.

Gemäß einer Ausführungsform der Erfindung bleiben die abgespeicherten Zustandsdaten nach dem Versenden an die Bodenstation im nicht-flüchtigen Speicher gespeichert. Die Zustandsdaten können über einen gewissen Zeitraum automatisch zum Auslesen bereitstehen, bevor sie gelöscht werden oder mit neuen Zustandsdaten überschrieben werden.

Ein weiterer Aspekt der Erfindung betrifft ein Verstärkermodul für einen Kommunikationssatelliten. Ein Modul kann beispielsweise eine Baugruppe mit einem gemeinsamen Gehäuse oder einem gemeinsamen Trägerelement sein, an dem die Komponenten des Verstärkermoduls befestigt sind und/oder mit dem die Komponenten des Verstärkermoduls, wie etwa eine Steuerung, ein Schutzfunktionsbaustein, ein Telemetriebaustein, die Verstärkereinheit, wie etwa eine Wanderfeldröhre oder ein Halbleiterverstärker usw., gemeinsam im Satelliten verbaut werden können.

Gemäß einer Ausführungsform der Erfindung umfasst das Verstärkermodul eine Verstärkereinheit und eine Steuerung zum Ansteuern der Verstärkereinheit. Die Verstärkereinheit kann eine Wanderfeldröhre sein. Die Wanderfeldröhre kann beispielsweise umfassen: einen Emitter, der dazu ausgeführt ist, bei Anlegen einer Spannung einen Elektronenstrahl zu erzeugen; einen Verstärkerabschnitt, der von dem Elektronenstrahl durchlaufen wird, in dem ein Leiter angeordnet ist, und in dem ein den Leiter durchlaufendes Hochfrequenzsignal durch den Elektronenstrahl verstärkbar ist; und einen Kollektor, der dazu ausgeführt ist, den Elektronenstrahl aufzunehmen und an den Emitter zurückzuführen.

Das Verstärkermodul kann zusätzlich einen Vorverstärker und/oder einen Linearisierer umfassen, der beispielsweise in einer gemeinsamen Baugruppe mit den anderen Komponenten des Verstärkermoduls verbaut ist.

Es ist möglich, dass bei einem Wanderfeldröhrenmodul zwei Wanderfeldröhren von einer Stromversorgung versorgt werden und eventuell einen gemeinsamen Vorverstärker oder jede Wanderfeldröhre individuell einen Vorverstärker aufweist.

Weiter umfasst die Steuerung einen nicht-flüchtigen, beschreibbaren Speicher, der dazu ausgeführt ist, Zustandsdaten des Verstärkermoduls zu speichern, wenn das Verstärkermodul nicht von einer externen Stromversorgung des Satelliten bestromt ist. Der nicht-flüchtige Speicher kann beispielsweise in einem besonderen Chip vorgesehen sein, der separat von der Elektronik der Steuerung im Verstärkermodul verbaut sein kann.

Der nicht-flüchtige Speicher und/oder die Steuerung können in der Stromversorgung (bzw. im Gehäuse der Stromversorgung) des Verstärkermoduls untergebracht sein. Der nicht-flüchtige Speicher und/oder die Steuerung können auch in einem Vorverstärker und/oder Linearisierer, oder aber auch ein Teil in der Stromversorgung und der andere im Vorverstärker und/oder Linearisierer untergebracht sein.

Um Informationen über einen ungewünschten Zustand des Verstärkermoduls auch dann bereitstellen zu können, wenn es abgeschaltet bzw. deaktiviert wurde, ist die Steuerung dazu ausgeführt, das Betriebsverfahren auszuführen, so wie es obenstehend und untenstehend beschrieben ist. Es ist zu verstehen, dass Merkmale des Verstärkermoduls auch Merkmale des Verfahrens sein können und umgekehrt.

Gemäß einer Ausführungsform der Erfindung umfasst die Steuerung einen Telemetriebaustein, der dazu ausgeführt ist, Betriebsparameter und/oder einstellbare Parameter des Verstärkermoduls als Zustandsdaten zu erfassen. Der Telemetriebaustein kann beispielsweise Messsensoren ansteuern und die erhaltenen Messwerte in digitaler Form bereitstellen.

Gemäß einer Ausführungsform der Erfindung umfasst die Steuerung einen Schutzfunktionsbaustein, der dazu ausgeführt ist, Betriebsparameter und/oder einstellbare Parameter des Verstärkermoduls als Zustandsdaten auszuwerten, um einen ungewünschten Zustand des Verstärkermoduls zu bestimmen. Beispielsweise kann der Telemetriebaustein dem Schutzfunktionsbaustein diese Parameter zur Verfügung stellen.

Gemäß einer Ausführungsform der Erfindung umfasst das Verstärkermodul weiter eine Telekommandoschnittstelle, die dazu ausgeführt ist, ein Telekommando von einer Bodenstation zu empfangen, das ein Versenden von im nicht-flüchtigen Speicher gespeicherten Zustandsdaten auslöst. Beispielsweise kann diese Telekommandoschnittstelle eine externe Schnittstelle des Verstärkermoduls sein, mit dem das Verstärkermodul mit einer weiteren Steuerung des Satelliten kommunizieren kann.

Zusammenfassend können ein derartiges Betriebsverfahren und ein derartiges Verstärkermodul die folgenden Vorteile aufweisen: Bei einer Fehlfunktion des Verstärkermoduls steht eine Information zur Verfügung, welche Schutzschaltung bzw. Schutzfunktion angesprochen hat. Bei wiederholten Fehlfunktionen kann festgestellt werden, ob immer die gleiche Ursache vorliegt. Zeitnah zum Auftreten der Fehlfunktion erfasste Telemetriedaten können Aufschluss über den Betriebszustand des Verstärkermoduls zum Zeitpunkt des Fehlers geben. Diese Information kann zur Fehlersuche verwendet werden, um die Fehlerursache zu lokalisieren.

Im Folgenden werden Ausführungsbeispiele der Erfindung mit Bezug auf die beiliegenden Figuren detailliert beschrieben.

### KURZE BESCHREIBUNG DER FIGUREN

Fig. 1 zeigt eine schematische Ansicht eines Kommunikationssatelliten gemäß einer Ausführungsform der Erfindung.
Fig. 2 zeigt eine schematische Ansicht eines Verstärkermoduls gemäß einer Ausführungsform der Erfindung.
Fig. 3 zeigt ein Flussdiagramm für ein Verfahren zum Betreiben eines Verstärkermoduls gemäß einer Ausführungsform der Erfindung.

Grundsätzlich sind identische oder ähnliche Teile mit den gleichen Bezugszeichen versehen.

### DETAILLIERTE BESCHREIBUNG VON AUSFÜHRUNGSBEISPIELEN

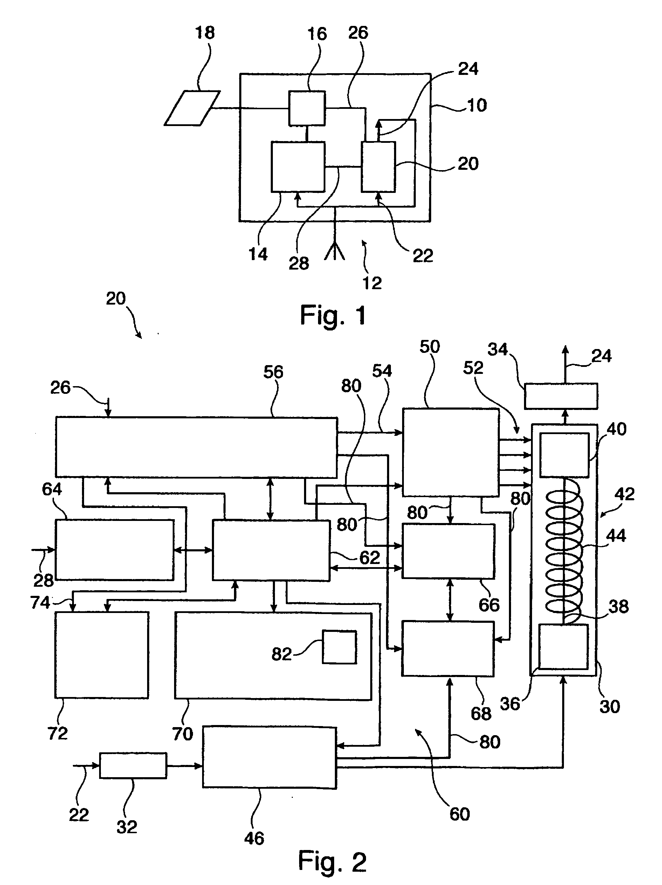

Fig. 1 zeigt einen Kommunikationssatelliten 10 mit einer Antenne 12, einer Hauptsteuereinheit bzw. Hauptsteuerung 14 und einer Stromversorgung 16, die beispielsweise von einem Sonnenpanel 18 mit Energie versorgt wird.

Weiter weist der Kommunikationssatellit 10 ein Verstärkermodul 20 in der Form eines Wanderfeldröhrenmoduls 20 auf. In der Fig. 1 ist lediglich ein Kanal des Kommunikationssatelliten 10 dargestellt, in der Regel kann ein Kommunikationssatellit 10 mehrere Kanäle aufweisen, die jeweils ein Wanderfeldröhrenmodul 20 umfassen können.

Über die Antenne 12 kann der Kommunikationssatellit 10 ein Hochfrequenzsignal 22 empfangen und an das Wanderfeldröhrenmodul 20 weiterleiten. Dort wird das Hochfrequenzsignal 22 zu einem verstärkten Hochfrequenzsignal 24 verstärkt und kann wieder über die Antenne 12 (oder eine weitere Antenne) abgestrahlt werden. Über die Stromversorgung 16 wird das Wanderfeldröhrenmodul 20 dabei mit Spannung 26 versorgt. Weiter kann das Wanderfeldröhrenmodul 20 von der Steuereinheit 14 angesteuert werden und beispielsweise Telekommandos 28 empfangen, die beispielsweise über die Antenne 12 empfangen und von der Steuereinheit 14 ausgewertet wurden.

Die Fig. 2 zeigt ein Wanderfeldröhrenmodul 20 detaillierter als Blockschaltbild. Das Wanderfeldröhrenmodul 20 umfasst eine Wanderfeldröhre 30, die über einen Hochfrequenzeingang 32 das Hochfrequenzsignal 22 empfängt und das verstärkte Hochfrequenzsignal 24 über einen Hochfrequenzausgang 34 ausgibt.

Die Wanderfeldröhre 30 umfasst einen Emitter 36, mit dem ein Elektronenstrahl 38 erzeugt werden kann und einen Kollektor 40, der den Elektronenstrahl 38 wieder aufnimmt. Auf diese Weise kann der elektrische Strom aus dem Elektronenstrahl 38 wieder zum Emitter 36 zurückgeführt werden. Zwischen dem Emitter und dem Kollektor 38 liegt ein Verstärkerbereich 42, in dem das Hochfrequenzsignal 22 durch den Elektronenstrahl 38 verstärkt wird. Das Hochfrequenzsignal 22 wird dabei durch einen wendelförmigen Leiter 44 durch die Wanderfeldröhre 30 geschickt.

Zwischen dem Hochfrequenzeingang 32 und der Wanderfeldröhre 30 kann das Wanderfeldröhrenmodul 20 einen Kanalverstärker und/oder Linearisierer 46 aufweisen, mit dem das unverstärkte Hochfrequenzsignal 22 vorverstärkt und/oder linearisiert werden kann, bevor es der Wanderfeldröhre 30 zugeführt wird.

Die restlichen Komponenten des Wanderfeldröhrenmoduls 20 stellen die Stromversorgung für die Wanderfeldröhre 30 dar.

Die Wanderfeldröhre 30 wird von Hochspannungserzeugung 50 mit einer Mehrzahl von Versorgungsspannungen 52 versorgt, beispielsweise einer Anodenspannung, einer oder mehreren Kollektorspannungen, einer Kathodenspannung des Emitters, usw.

Eine Versorgungsspannung 54 für die Hochspannungserzeugung 50 wird von einem Vorregler und Filter 56 bereitgestellt, der die Spannung 26 aus der Stromversorgung 16 des Satelliten 10 zu einer konstanten und gleichmäßigen Gleichspannung umwandelt.

Das Wanderfeldröhrenmodul 20 umfasst weiter eine Steuerung 60, die einen zentralen Baustein 62, eine Telemetrie- und Telekommando-Schnittstelle 64, einen Schutzfunktionsbaustein 66, einen Telemetriebaustein 68 und einen nicht-flüchtigen Datenspeicher 70 umfasst. Die Steuerung 60 bzw. ihre Komponenten 62, 64, 66, 68, 70 werden von einer Hilfsspannungsversorgung 72, die von dem Vorregler und Filter 56 mit einer Spannung 74 versorgt wird, mit Spannung versorgt.

Im Telemetriebaustein 68 werden die Telemetriedaten bzw. Betriebsparameter und einstellbare Parameter 80 des Wanderfeldröhrenmoduls 20 erfasst und gesammelt. Beispielsweise kann der Telemetriebaustein 68 Sensordaten von der Hochspannungserzeugung 50, dem Vorregler und Filter 56 und dem Kanalverstärker und/oder Linearisierer 46 erfassen und diese in digitale Form umwandeln. Im Schutzfunktionsbaustein 66 werden Schutzfunktionen und/oder Alarmfunktionen ausgeführt, die überprüfen, ob sich erfasste Parameter 80 im gewünschten Rahmen bewegen. Dazu kann der Schutzfunktionsbaustein 66 diese Parameter direkt erfassen und/oder sie von dem Telemetriebaustein 68 zur Verfügung gestellt bekommen. Beispiele für Schutzfunktionen sind Unterspannungsschutz, Überlastschutz, usw.

Im nicht-flüchtigen Datenspeicher 70 bzw. Speicherbaustein 70 können fest definierte Daten abgespeichert bzw. können aktuelle Daten, wie beispielsweise Betriebsparameter und einstellbare Parameter 80, als Zustandsdaten 82 abgespeichert werden. Wird eine Schutzfunktion aktiviert, kann die Steuerung 60 den auslösenden Parameter 70 bestimmen, optional alle Telemetriedaten aufnehmen und diese Information im Datenspeicher 70 abspeichern. Da es sich um einen nicht-flüchtigen Speicher 70 handelt, stehen die Zustandsdaten 82 auch zur Verfügung, nachdem das Verstärkermodul 20 wieder eingeschaltet wurde bzw. automatisch wieder eingeschaltet hat und einige Zeit unbestromt war.

Die Telemetrie- und Telekommandoschnittstelle 64 steht mit den anderen Komponenten 14 des Satelliten 10 in Verbindung und stellt somit eine Verbindung zur Kontrollstation am Boden dar. Über die Schnittstelle kann das Verstärkermodul 20 bzw. die Steuerung 60 Telekommandos, wie etwa Steuerungskommandos, erhalten bzw. das Verstärkermodul 20 bzw. die Steuerung 64 Daten über den Betriebszustand liefern.

Der zentrale Baustein 62 der Steuerung 64 kann dabei alle Vorgänge, wie etwa das Auslösen der Schutzfunktion, das Abspeichern und Auslesen der Zustandsdaten, usw., regeln und kontrollieren.

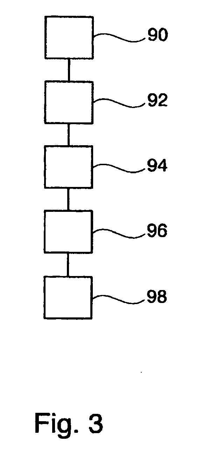

Die Fig. 3 zeigt ein Flussdiagramm, mit dem das Verstärkermodul 20 betrieben werden kann.

Im Schritt 90 wird ein ungewünschter Zustand des Verstärkermoduls 20 festgestellt. Dazu kann das Schutzfunktionsmodul erfasste Parameter 70, die beispielsweise von dem Telemetriebaustein 68 stammen, jeweils mit einem Schwellwert vergleichen und einen Alarm auslösen, wenn der Schwellwert über- oder unterschritten wurde.

Beispielsweise kann ein Alarm für eine Spannungsunterversorgung ausgelöst werden, wenn die Eingangsleistung des Vorreglers und Filters 56 unter einen bestimmten Wert fällt. Auch kann ein Alarm für eine Überspannung ausgelöst werden, wenn beispielsweise die Kollektorspannung der Wanderfeldröhre einen bestimmten Wert überschreitet.

Nachdem der ungewünschte Zustand festgestellt wurde, werden im Schritt 92 Zustandsdaten 82, die auf den ungewünschten Zustand hinweisen, in dem nicht-flüchtigen Speicher 70 abgespeichert. Dies kann beispielsweise durch den zentralen Baustein 62 der Steuerung 64 erfolgen, der den Alarm der Schutzfunktion empfängt und die abzuspeichernden Zustandsdaten 82 bzw. die zugehörigen Parameter ausliest.

Die abgespeicherten Zustandsdaten 82 können dabei die Art der Schutzfunktion und/oder den Zeitpunkt, zu dem die Schutzfunktion ausgelöst wurde, umfassen. Beispielsweise können die Schutzfunktionen nummeriert sein und die entsprechende Nummer in den Zustandsdaten 82 gespeichert werden.

Die abgespeicherten Zustandsdaten 82 können Werte von Parametern 70 des Verstärkermoduls 20 umfassen, die durch die Schutzfunktion verarbeitet wurden, wie etwa die Eingangsleistung oder die Kathodenspannung.

Weiter können die abgespeicherten Zustandsdaten 82 Werte von weiteren, anderen Parametern 70 des Verstärkermoduls 20 umfassen, die vor dem Feststellen des ungewünschten Zustands erfasst wurden und/oder die vor dem Deaktivieren des Verstärkermoduls 20 erfasst wurden. Beispielsweise können jedes Mal, wenn Zustandsdaten 82 gespeichert werden, alle Spannungs- und Stromwerte, die für die Wanderfeldröhre 30 erfasst wurden, mitgespeichert werden.

Nach dem Abspeichern der Zustandsdaten 82 wird im Schritt 94 das Verstärkermodul 20 deaktiviert. Beispielsweise kann der zentrale Baustein 62 der Steuerung 60 den Vorregler und Filter 56 anweisen, das Verstärkermodul 20 von seiner Versorgungsspannung zu trennen.

Im Schritt 96 wird das Verstärkermodul 20 wieder aktiviert, beispielsweise über eine externe Steuerung 14 des Satelliten 10, die den Startvorgang beispielsweise automatisch nach einer gewissen Zeit ausführt oder von einem entsprechenden Telekommando der Bodenstation dazu veranlasst wird.

Im Schritt 98 werden die abgespeicherten Zustandsdaten 82 an die Bodenstation versendet. Dies kann beispielsweise dadurch veranlasst werden, dass die Steuerung 64 ein entsprechendes Telekommando 28 von der Bodenstation erhält und/oder dass die Steuerung 64 die abgespeicherten Zustandsdaten 82 automatisch versendet, nachdem das Verstärkermodul 20 reaktiviert wurde. Dazu kann die Steuerung 64 beispielsweise nach dem Starten des Verstärkermoduls 20 im nicht-flüchtigen Speicher 70 nachsehen, ob nicht-gesendete Zustandsdaten 82 vorhanden sind und diese dann anschließend an die Bodenstation versenden. Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Verfahren zum Betreiben eines Verstärkermoduls (20) eines Kommunikationssatelliten (10), das Verfahren umfassend die Schritte:
Feststellen eines ungewünschten Zustandes des Verstärkermoduls (20);
Abspeichern von Zustandsdaten (82), die auf den ungewünschten Zustand hinweisen, in einem nicht-flüchtigen Speicher (70) des Verstärkermoduls (20), nachdem der ungewünschte Zustand festgestellt wurde;
Deaktivieren des Verstärkermoduls (20) nach dem Abspeichern der Zustandsdaten (82).

2. Verfahren nach Anspruch 1,
wobei der ungewünschte Zustand durch Ausführen einer Schutzfunktion festgestellt wird, die auf erfasste Parameter (80) des Verstärkermoduls (20) angewendet wird und die aus den erfassten Parametern (80) den ungewünschten Zustand ermittelt.

3. Verfahren nach Anspruch 2,
wobei die abgespeicherten Zustandsdaten (82) die Art der Schutzfunktion umfassen.

4. Verfahren nach Anspruch 2 oder 3,
wobei die abgespeicherten Zustandsdaten (82) Werte von Parametern (70) des Verstärkermoduls (20) umfassen, die durch die Schutzfunktion verarbeitet wurden.

5. Verfahren nach einem der vorhergehenden Ansprüche,
wobei die abgespeicherten Zustandsdaten (82) Werte von Parametern (70) des Verstärkermoduls (20) umfassen, die vor dem Feststellen des ungewünschten Zustands erfasst wurden und/oder die vor dem Deaktivieren des Verstärkermoduls (20) erfasst wurden.

6. Verfahren nach einem der vorhergehenden Ansprüche, weiter umfassend die Schritte:
Feststellen eines weiteren ungewünschten Zustandes und Abspeichern von weiteren Zustandsdaten (82), die den weiteren ungewünschten Zustand betreffen, so dass die Zustandsdaten und die weiteren Zustandsdaten zusammen in dem nicht-flüchtigen Speicher (70) gespeichert sind.

7. Verfahren nach einem der vorhergehenden Ansprüche, weiter umfassend den Schritt:
Senden der abgespeicherten Zustandsdaten (82) an eine Bodenstation.

8. Verfahren nach Anspruch 7,
wobei die abgespeicherten Zustandsdaten (82) versendet werden, wenn das Verstärkermodul (20) ein entsprechendes Telekommando (28) von der Bodenstation erhält.

9. Verfahren nach Anspruch 7,
wobei die abgespeicherten Zustandsdaten (82) automatisch versendet werden, nachdem das Verstärkermodul (20) reaktiviert wurde.

10. Verfahren nach einem der Ansprüche 7 bis 9,
wobei die abgespeicherten Zustandsdaten (82) nach dem Versenden an die Bodenstation im nicht-flüchtigen Speicher (70) gespeichert bleiben.

11. Verstärkermodul (20) für einen Kommunikationssatelliten (10), umfassend:
eine Verstärkereinheit (30); und
eine Steuerung (60) zum Ansteuern der Verstärkereinheit (30);
wobei die Steuerung (60) einen nicht-flüchtigen, beschreibbaren Speicher (70) umfasst, der dazu ausgeführt ist, Zustandsdaten (82) des Verstärkermoduls (20) zu speichern, wenn das Verstärkermodul (20) nicht von einer externen Stromversorgung (16) bestromt ist;
wobei die Steuerung (60) dazu ausgeführt ist, das Verfahren nach einem der Ansprüche 1 bis 10 auszuführen.

12. Verstärkermodul (20) nach Anspruch 11,
wobei die Steuerung (60) einen Telemetriebaustein (68) umfasst, der dazu ausgeführt ist, Betriebsparameter und/oder einstellbare Parameter (80) des Verstärkermoduls (20) als Zustandsdaten (82) zu erfassen.

13. Verstärkermodul (20) nach Anspruch 11 oder 12,
wobei die Steuerung (60) einen Schutzfunktionsbaustein (66) umfasst, der dazu ausgeführt ist, Betriebsparameter und/oder einstellbare Parameter (80) des Verstärkermoduls (20) auszuwerten, um einen ungewünschten Zustand des Verstärkermoduls (20) zu bestimmen.

14. Verstärkermodul (20) nach einem der Ansprüche 11 bis 13, weiter umfassend:
eine Telekommandoschnittstelle (66), die dazu ausgeführt ist, ein Telekommando (28) zu empfangen, das ein Versenden von im nicht-flüchtigen Speicher (70) gespeicherten Zustandsdaten (82) auslöst.

15. Verstärkermodul (20) nach einem der Ansprüche 11 bis 14, weiter umfassend:
eine Wanderfeldröhre als Verstärkereinheit (30).

## Claims

1. Method for operating an amplifier module (20) of a communication satellite (10), the method comprising the steps of:
detection of an undesired state of the amplifier module (20);
storage of state data (82) that indicate the undesired state in a non-volatile memory (70) of the amplifier module (20) after the undesired state has been detected;
deactivation of the amplifier module (20) after the storage of the state data (82).

2. Method according to Claim 1,
wherein the undesired state is detected by executing a protective function that is applied to recorded parameters (80) of the amplifier module (20) and that ascertains the undesired state from the recorded parameters (80).

3. Method according to Claim 2,
wherein the stored state data (82) comprise the type of the protective function.

4. Method according to Claim 2 or 3,
wherein the stored state data (82) comprise values of parameters (70) of the amplifier module (20) that have been processed by the protective function.

5. Method according to one of the preceding claims, wherein the stored state data (82) comprise values of parameters (70) of the amplifier module (20) that have been recorded before the detection of the undesired state and/or that have been recorded before the deactivation of the amplifier module (20).

6. Method according to one of the preceding claims, additionally comprising the steps of:
detection of a further undesired state and storage of further state data (82) that relate to the further undesired state, so that the state data and the further state data are stored together in the non-volatile memory (70).

7. Method according to one of the preceding claims, additionally comprising the step of:
sending of the stored state data (82) to a ground station.

8. Method according to Claim 7,
wherein the stored state data (82) are sent when the amplifier module (20) receives an appropriate telecommand (28) from the ground station.

9. Method according to Claim 7,
wherein the stored state data (82) are sent automatically after the amplifier module (20) has been reactivated.

10. Method according to one of Claims 7 to 9,
wherein the stored state data (82) remain stored in the non-volatile memory (70) after having been sent to the ground station.

11. Amplifier module (20) for a communication satellite (10), comprising
an amplifier unit (30); and
a controller (60) for actuating the amplifier unit (30) ;
wherein the controller (60) comprises a non-volatile, writable memory (70) that is designed to store state data (82) from the amplifier module (20) when the amplifier module (20) is not powered by an external power supply (16);
wherein the controller (60) is designed to carry out the method according to one of Claims 1 to 10.

12. Amplifier module (20) according to Claim 11, wherein the controller (60) comprises a telemetry chip (68) that is designed to record operating parameters and/or adjustable parameters (80) of the amplifier module (20) as state data (82).

13. Amplifier module (20) according to Claim 11 or 12, wherein the controller (60) comprises a protective function chip (66) that is designed to evaluate operating parameters and/or adjustable parameters (80) of the amplifier module (20) in order to determine an undesired state of the amplifier module (20).

14. Amplifier module (20) according to one of Claims 11 to 13, additionally comprising:
a telecommand interface (66) that is designed to receive a telecommmand (28) that initiates sending of state data (82) stored in the non-volatile memory (70).

15. Amplifier module (20) according to one of Claims 11 to 14, additionally comprising:
a travelling wave tube as amplifier unit (30).

## Revendications

1. Procédé de fonctionnement d'un module d'amplification (20) d'un satellite de télécommunication (10), le procédé comprenant les étapes consistant à :
constater un état non souhaité du module d'amplification (20),
mémoriser des données d'état (82) qui renseignent sur l'état non souhaité, dans une mémoire non volatile (70) du module d'amplification (20), après que l'état non souhaité a été constaté,
désactiver le module d'amplification (20) après la mémorisation des données d'état (82).

2. Procédé selon la revendication 1 pour lequel l'état non souhaité est constaté par exécution d'une fonction de protection qui est appliquée à des paramètres détectés (80) du module d'amplification (20) et qui détermine l'état non souhaité à partir des paramètres détectés (80).

3. Procédé selon la revendication 2 pour lequel les données d'état mémorisées (82) comprennent le type de fonction de protection.

4. Procédé selon la revendication 2 ou 3 pour lequel les données d'état mémorisées (82) comprennent des valeurs de paramètres (70) du module d'amplification (20) qui ont été traitées par la fonction de protection.

5. Procédé selon l'une quelconque des revendications précédentes pour lequel les données d'état mémorisées (82) comprennent des valeurs de paramètres (70) du module d'amplification (20) qui ont été saisies avant la constatation de l'état non souhaité et/ou qui ont été saisies avant la désactivation du module d'amplification (20).

6. Procédé selon l'une quelconque des revendications précédentes, comprenant en plus les étapes consistant à :
constater un autre état non souhaité et mémoriser d'autres données d'état (82) qui concernent l'autre état non souhaité de telle manière que les données d'état et les autres données d'état sont mémorisées ensemble dans la mémoire non volatile (70).

7. Procédé selon l'une quelconque des revendications précédentes, comprenant en plus l'étape consistant à :
envoyer les données d'état mémorisées (82) à une station au sol.

8. Procédé selon la revendication 7 pour lequel les données d'état mémorisées (82) sont envoyées lorsque le module d'amplification (20) reçoit une télécommande correspondante (28) de la station au sol.

9. Procédé selon la revendication 7 pour lequel les données d'état mémorisées (82) sont automatiquement envoyées après que le module d'amplification (20) a été réactivé.

10. Procédé selon l'une quelconque des revendications 7 à 9 pour lequel les données d'état mémorisées (82) restent mémorisées dans la mémoire non volatile (70) après l'envoi à la station au sol.

11. Module d'amplification (20) pour un satellite de télécommunication (10) comprenant :
une unité d'amplification (30), et
une commande (60) pour piloter l'unité d'amplification (30),
pour lequel la commande (60) comprend une mémoire inscriptible non volatile (70) qui est constituée pour mémoriser les données d'état (82) du module d'amplification (20) lorsque le module d'amplification (20) n'est pas alimenté en courant par une alimentation en courant externe (16),
pour lequel la commande (60) est constituée pour exécuter le procédé selon l'une quelconque des revendications 1 à 10.

12. Module d'amplification (20) selon la revendication 11 pour lequel la commande (60) comprend un module de télémétrie (68) qui est réalisé pour saisir les paramètres de fonctionnement et/ou les paramètres réglables (80) du module d'amplification (20) en tant que données d'état (82).

13. Module d'amplification (20) selon la revendication 11 ou 12 pour lequel la commande (60) comprend un module de fonction de protection (66), qui est réalisé pour évaluer les paramètres de fonctionnement et/ou les paramètres réglables (80) du module d'amplification (20) pour définir un état non souhaité du module d'amplification (20).

14. Module d'amplification (20) selon l'une quelconque des revendications 11 à 13 comprenant en plus :
une interface de télécommande (66) qui est constituée pour recevoir une télécommande (28) qui déclenche un envoi des données d'état (82) mémorisées dans la mémoire non volatile (70).

15. Module d'amplification (20) selon l'une quelconque des revendications 11 à 14 comprenant en plus :
un tube à ondes progressives en tant qu'unité d'amplification (30).
